# EUROPEAN PATENT APPLICATION

(11) **EP 3 579 266 A1**
(43) Date of publication of application: **11.12.2019**
(21) Application number: 18897865.4
(22) Date of filing: 02.12.2018
(51) Int. Cl.: H01L 21/77

(54) **OLED DISPLAY MODULE HAVING TOUCH CONTROL FUNCTION, OLED DISPLAY, AND TERMINAL DEVICE**

(71) Applicant: SHENZHEN GOODIX TECHNOLOGY CO., LTD., Shenzhen, Guangdong 518045 (CN)
(72) Inventor: HAO, Qiyi, Shenzen, Guangdong 518045 (CN)
(74) Representative: Elzaburu S.L.P.
(86) International application number: PCT/CN2018/076391
(87) International publication number: WO 2019/153320

(57) **Abstract**

The present application provides an OLED display module with a touch function, an OLED display and a terminal device. The OLED display module includes: a plurality of first light emitting components, a plurality of second light emitting components and a plurality of light receiving components, where the plurality of second light emitting components and the plurality of light receiving components are disposed between the plurality of first light emitting components; where the first light emitting components are OLEDs, and the OLEDs are configured to implement a display function of the OLED display module; the second light emitting components are configured to emit light to implement the touch function of the OLED display module; and the light receiving components are configured to receive reflected light of the light emitted by the second light emitting component and convert the reflected light into electrical signals; where the electrical signal is configured to detect touch information on the OLED display module. On this basis, a waterproof performance can be improved, and touch reliability and sensitivity can be improved.

## Description

### Technical field

The present application relates to the field of touch technologies, and in particular, to an organic light-emitting diode (OLED) display module with a touch function, an OLED display, and a terminal device.

### Background

With the continuous development of touch display screen technology, more and more terminal devices adopt touch display screen technology to improve user experience.

At present, most touch display screens are capacitive display screens. Capacitive display screens are made by pasting a layer of transparent special metal conductive material on the surface of glass. When a finger touches the metal layer, a capacitance of a contact changes, which causes a frequency of an oscillator connected to the contact changes, and a touch operation may be detected by measuring the frequency change.

However, when the capacitive display screen encounters water, a capacitance generated by the water and the capacitance generated by the finger are close in terms of magnitude. In this case, the touch operation may not be detected normally, resulting in a problem of low touch reliability.

### Summary

The application provides an OLED display module with a touch function, an OLED display and a terminal device. Thereby, a waterproof effect may be achieved, and touch reliability and sensitivity are improved.

The present application provides an OLED display module with a touch function, including: a plurality of first light emitting components, a plurality of second light emitting components and a plurality of light receiving components, where the plurality of second light emitting components and the plurality of light receiving components are disposed between the plurality of first light emitting components.

The first light emitting components are organic light emitting diodes (OLEDs), and the OLEDs are configured to implement a display function of the OLED display module.

The second light emitting components are configured to emit light to implement the touch function of the OLED display module.

The light receiving components are configured to receive reflected light of the light emitted by the second light emitting component and convert the reflected light into electrical signals; where the electrical signals are configured to detect touch information on the OLED display module.

An advantageous effect of the present application includes: when a display including the OLED display module encounters water, since a refractive index of water is smaller than a refractive index of a finger, when the light receiving components convert the reflected light of the water and finger into electrical signals, strengths of the two electrical signals are significantly different, and on this basis, it is easy for a processor to detect the touch information based on the electrical signals. That is, even if the display including the OLED display module encounters water, the normal detection of the touch information cannot be prevented, thereby improving touch reliability and sensitivity. Since the second light emitting components and the light receiving components are respectively disposed between the first light emitting components, in the present application, there is no need to design a sensor layer separately, and the entire OLED display module becomes thinner, which may thereby reduce production processes and improve production efficiency.

Optionally, the plurality of first light emitting components, the plurality of second light emitting components, and the plurality of light receiving components are arranged in an array; in each row of the array, the second light emitting components and the light receiving components are arranged at intervals with N OLED group disposed between adjacent second light emitting component and light receiving component, so that the array includes a plurality of OLED columns, a plurality of second light emitting component columns, and a plurality of light receiving component columns; where N is a positive integer greater than or equal to 1, and the OLED group includes a fixed number of OLEDs.

Optionally, the OLED group includes an OLED for emitting red light, an OLED for emitting green light, and an OLED for emitting blue light.

Optionally, the OLED display module further includes: at least one gate line, at least one source line, at least one driving line, and at least one detecting line.

One end of the gate line is connected to OLEDs included in at least one row in the array and second light emitting components included in the at least one row, and the other end of the gate line is connected to a driving chip, so that the driving chip controls the OLEDs included in the at least one row and the second light emitting components included in the at least one row to be turned on or off; one end of the source line is connected to at least one OLED column in the array, and the other end of the source line is connected to the driving chip, so that the driving chip controls a brightness of the at least one OLED column; one end of the driving line is connected to at least one second light emitting component column in the array, and the other end of the driving line is connected to the driving chip, so that the driving chip controls a brightness of the at least one second light emitting component column; one end of the detecting line is connected to at least one light receiving component column in the array, and the other end of the driving line is connected to the driving chip, so that each light receiving component included in the at least one light receiving component column outputs a respective electrical signal to the driving chip.

Optionally, the plurality of first light emitting components form an array, and the array includes a plurality of square matrixes composed of OLEDs; a second light emitting component and a light receiving component are respectively disposed in two adjacent square matrixes.

Optionally, the square matrixes are 2*2 square matrixes, 3*3 square matrixes or 4*4 square matrixes.

Optionally, a separator for isolating light is disposed between the second light emitting components and the light receiving components. Thereby, the touch accuracy and reliability are improved.

In a second aspect, the present application provides an OLED display including an OLED display module according to the first aspect or the alternative implementations of the first aspect.

In a third aspect, the present application provides a terminal device including an OLED display according to the second aspect.

### Brief description of drawings

In order to more clearly illustrate embodiments of the present application or technical solutions in the prior art, a brief description will be made below for the drawings required in describing the embodiments or the prior art. Obviously, the drawings in the following description are some embodiments of the present application, and other drawings can also be obtained according to the drawings without any creative work for those skilled in the art.
FIG. 1 is a schematic diagram of an OLED display module with a touch function according to an embodiment of the present application;
FIG. 2 is a schematic diagram of a touch detection principle according to an embodiment of the present application;
FIG. 3 is a schematic diagram of an OLED display module according to another embodiment of the present application;
FIG. 4 is a schematic diagram of an OLED display module according to still another embodiment of the present application;
FIG. 5 is a schematic diagram of an OLED display according to an embodiment of the present application;
FIG. 6 is a schematic diagram of a terminal device according to an embodiment of the present application; and
FIG. 7 is a schematic diagram of emitted light pulses according to an embodiment of the present application.

### Description of embodiments

In order to make the objectives, technical solutions and advantages of the embodiments of the present application clearer, the technical solutions in the embodiments of the present application are clearly and completely described below with reference to the accompanying drawings in the embodiments of the present application. Obviously, the described embodiments are a part of the embodiments of the present application, but not all of the embodiments. All the other embodiments obtained by those skilled in the art based on the embodiments of the present application without any creative work fall within the scope of the present application.

The terms "includes" and "including", and any variations thereof, in the specification and claims and the above drawings of the present application are intended to cover a non-exclusive inclusion, for example, a process, a method, a system, a product, or a device including a series of steps or units is not necessarily limited to those steps or units that are clearly listed, but may include other steps or units that are not explicitly listed or inherent to such process, method, product, or device.

At present, most touch screen displays are capacitive display screens. However, when a capacitive display screen encounters water, a capacitance generated by the water and the capacitance generated by the finger are close in terms of magnitude. In this case, the touch operation may not be detected normally, resulting in a problem of low touch reliability. In order to solve the above technical problem, the present application provides an OLED display module with touch function, an OLED display, and a terminal device.

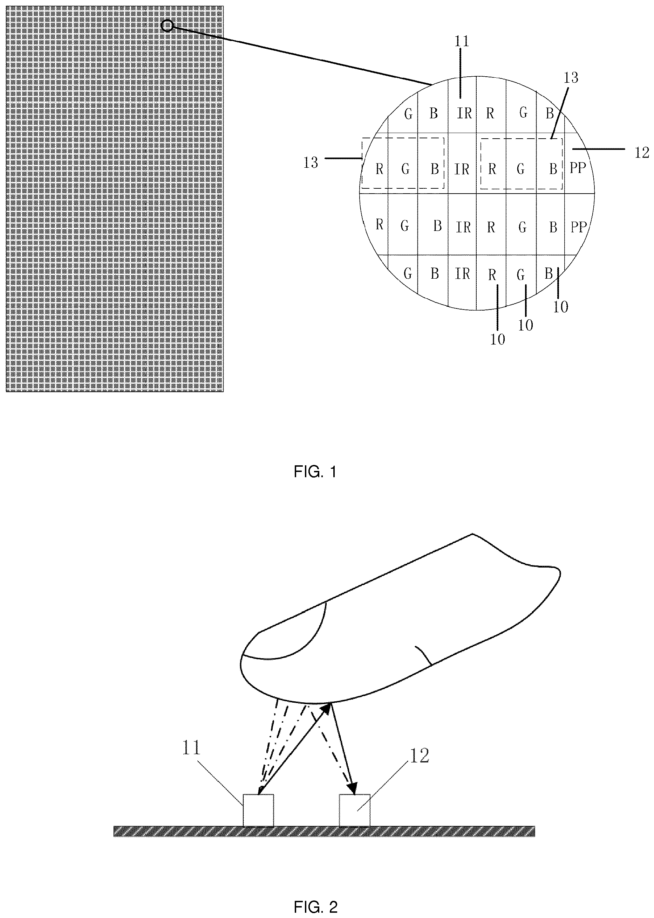

Specifically, FIG. 1 is a schematic diagram of an OLED display module with a touch function according to an embodiment of the present application. As shown in FIG. 1, the OLED display module with the touch function includes: a plurality of first light emitting components 10, a plurality of second light emitting components (second light emitting components are referred to as IR for short) 11 and a plurality of light receiving components (light receiving components are referred to as PP for short) 12.

The first light emitting components 10 are OLEDs, and the OLEDs are configured to implement a display function of the OLED display module; and the second light emitting components are configured to emit light to implement the touch function of the OLED display module; where the light emitted by the second light emitting components may be non-Red Blue Green (RGB) light, for example, the non-RGB light is infrared light. The purpose of the present application to define that the light emitted by the second light emitting components is non-RGB light is that: since the OLEDs emit red light, blue light or green light, and for the light receiving components below, they need to receive reflected light of the light emitted by the second light emitting component, rather than receiving the light emitted by the OLEDs, on this basis, the light emitted by the second light emitting components should be non-RGB light in order to prevent the light receiving components from receiving the light emitted by the OLEDs, .

The light receiving components 12 are configured to receive the reflected light of the light emitted by the second light emitting component and convert the reflected light into electrical signals. The electrical signals are configured to detect touch information on the OLED display module, and the touch information may include touch location information, or the like. The infrared receiving components can be photodiodes or phototransistors, or the like, which can generate different electrical signals according to light of different strengths.

Optionally, the second light emitting components 11 and the light receiving components 12 have an one-to-one corresponding relationship, that is, each second light emitting component 11 corresponds to one light receiving component 12; or, the second light emitting components 11 and the light receiving components 12 have an one-to-many or a many-to-one corresponding relationship. The corresponding relationship between the second light emitting components 11 and the light receiving components 12 is determined by a finger or another object, for example, when the finger reflects an emitted light of a second light emitting component 11, the light receiving component 12 that can receive the reflected light has a corresponding relationship with the second light emitting component 11. Regardless of whether the second light emitting components 11 and the light receiving components 12 have a one-to-one, one-to-many or many-to-one corresponding relationship, the light receiving components 12 are each configured to receive a reflected light of light emitted by its corresponding second light emitting component(s) 11.

Further, FIG. 2 is a schematic diagram of a touch detection principle according to an embodiment of the present application. As shown in FIG. 2, a second light emitting component 11 is configured to emit light, when a finger or another object approaches or touches the second light emitting component 11, the finger or the other object reflects the emitted light to generate reflected light, and then the light receiving component 12 corresponding to the second light emitting component 11 receives the reflected light that is the light of the second light emitting component 11 reflected by the user, and converts the reflected light into an electrical signal, so that a processor connected to the OLED display module detects touch information on the OLED display module according to the electrical signal. For example, when a signal strength of the electrical signal is greater than a preset strength, the processor detects the touch information on the OLED display module, and determines a touch position according to the touch information; when the signal strength of the electrical signal is less than or equal to the preset strength, the processor does not need to detect the touch information on the OLED display module. Here, the closer the distance of the finger to the second light emitting component 11 and the light receiving component 12, the stronger the strength of the electrical signal. Further, the preset strength may be set according to actual conditions, which is not limited in the present application. As described above, the corresponding relationship between the second light emitting components 11 and the light receiving components 12 may be many-to-one or one-to-many. On this basis, the processor may determine multiple pieces of touch information, but in the present application, the processor can filter out invalid touch information according to the signal strengths of the electrical signals and only retain one effective touch information as long as the preset strength is set appropriately, thereby improving the touch reliability.

It is worth mentioning that, in order to prevent the light emitted by the second light emitting component 11 from being directly received by the light receiving component 12, resulting in that the light receiving component 12 converts light directly received without being reflected by the finger into an electrical signal, which thereby affects the touch accuracy and reliability, in the present application, a separator may be disposed between the second light emitting components 11 and the light receiving components 12 for isolating the second light emitting component 11 to prevent the second light emitting components 11 from directly emitting light to the light receiving component 12, where the second light emitting component 11 may be disposed at a junction portion of the second light emitting component 11 and the light receiving component 12. The junction portion may be an end of the second light emitting component 11 close to the light receiving component 12, or an end of the light receiving component 12 close to the second light emitting component 11.

Further, the OLEDs, the second light emitting components and the light receiving components in the OLED display module have a plurality of arrangement manners, which make the structure of the OLED display module different, for example:

Optional structure 1: as shown in FIG. 1, the plurality of first light emitting components 10, the plurality of second light emitting components 11, and the plurality of light receiving components 12 included in the OLED display module with the touch function are arranged in an array. In each row of the array, the second light emitting components 11 and the light receiving components 12 are arranged at intervals with N OLED group(s) 13 disposed between adjacent second light emitting component 11 and light receiving component 12, so that the array includes a plurality of OLED columns, a plurality of second light emitting component columns, and a plurality of light receiving component columns; where N is a positive integer greater than or equal to 1. For example, as shown in FIG. 1, an OLED group is disposed between the adjacent second light emitting component 11 and light receiving component 12, and of course, a plurality of OLED groups may be disposed between the adjacent second light emitting component 11 and light receiving component 12, which is not limited in the present application. The OLED group 13 includes a fixed number of OLEDs. Optionally, as shown in FIG. 1, the OLED group 13 includes an OLED for emitting red light (R), an OLED for emitting green light (G), and an OLED for emitting blue light (B) .

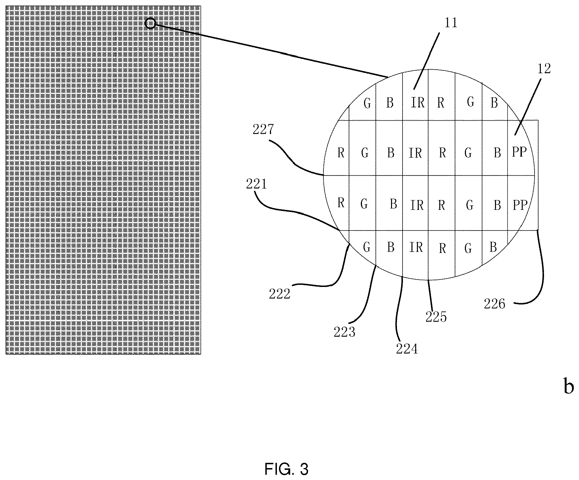

Further, in an actual application process, a driving circuit is configured to control the OLED display module, and thus the OLED display module further includes a connection line connected to the driving circuit, or the like. Specifically, FIG. 3 is a schematic diagram of an OLED display module according to another embodiment of the present application. As shown in FIG. 3, the display module includes: at least one gate line 221, 227; at least one source line 222, 223, 224, at least one driving line 225 and at least one detecting line 226.

One end of the gate line is connected to OLEDs included in at least one row in the array and second light emitting components included in the at least one row, and the other end of the gate line is connected to a driving chip, so that the driving chip controls the OLEDs included in the at least one row and the second light emitting components included in the at least one row to be turned on or off. Taking each gate line being connected to the OLEDs and second light emitting components included in one row of the array as an example, when the gate line 221 is turned on, it controls to turn on the OLEDs and the second light emitting components of a corresponding row, and the light receiving components are responsible for receiving the reflected light of the light emitted by the second light emitting components. Then, when the gate line 227 is turned on, it controls to turn on the OLEDs and the second light emitting components of a corresponding row, and the light receiving components are responsible for receiving the reflected light of the light emitted by the second light emitting components. In this way, each area of the entire display module has a process of light emission and light reception. When a finger touches, a light receiving component receives the reflected light reflected by the finger and converts it into an electrical signal, and the processor can detect the touch information through the electrical signal and control the OLED display module according to the touch.

Further, as shown in FIG. 1, in each row of the array, one OLED group 13 is disposed between adjacent second light emitting component 11 and light receiving components 12, and thus the OLEDs are arranged in columns, the second light emitting components are also arranged in columns, and the light receiving components are arranged in columns too. On this basis, one end of the source line is connected to at least one OLED column in the array, and the other end of the source line is connected to the driving chip, so that the driving chip controls a brightness of the at least one OLED column, where the OLED column refers to a column composed of OLEDs. One end of the driving line is connected to at least one second light emitting component column in the array, and the other end of the driving line is connected to the driving chip, so that the driving chip controls a brightness of the at least one second light emitting component column, where, the second light emitting component column refers to a column composed of the second light emitting components. One end of the detecting line is connected to at least one light receiving component column in the array, and the other end of the driving line is connected to the driving chip, so that each light receiving component included in the at least one light receiving component column outputs a respective electrical signal to the driving chip, where the light receiving component column refers to a column composed of the light receiving components.

In fact, since the OLED is small and the finger is relatively large with respect to the OLED, the OLED display module also has the following optional structure:

Optional structure 2: the plurality of first light emitting components form an array, and the array includes a plurality of square matrixes; a second light emitting component and a light receiving component are respectively disposed in two adjacent square matrixes. The square matrixes are 2*2 square matrixes, 3*3 square matrixes or 4*4 square matrixes. The 2*2 square matrix represents a square matrix having 2 rows and 2 columns, the 3*3 square matrix represents a square matrix having 3 rows and 3 columns, and the 4*4 square matrix represents a square matrix having 4 rows and 4 columns. The number of rows and columns of the square matrix is not limited in the present application, as long as the distance between the second light emitting component and the light receiving component in two adjacent square matrixes is less than a preset distance, that is, a touch detection is not affected. The preset distance can be set according to actual conditions, for example, it may be 4 mm.

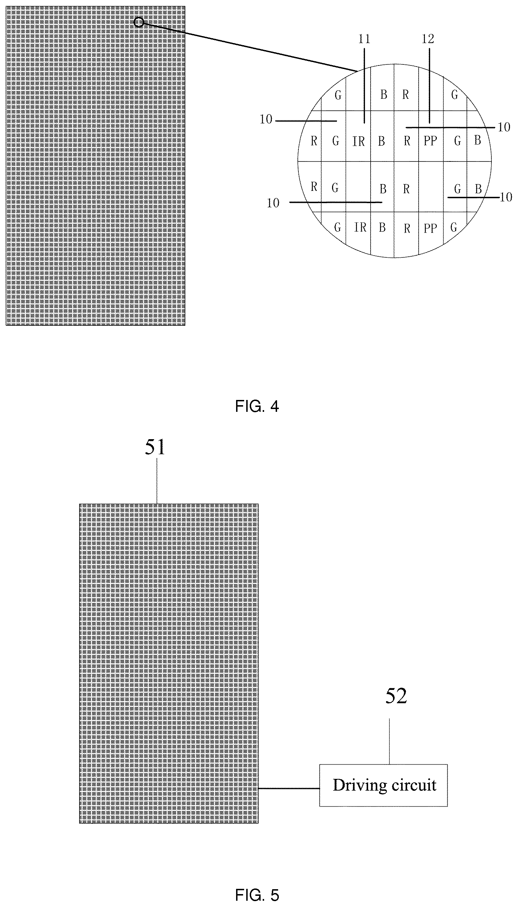

FIG. 4 is a schematic diagram of an OLED display module according to still another embodiment of the present application. As shown in FIG. 4, a 2*2 square matrix on the left side is composed of four OLEDs 10 (which are two OLEDs emitting green light and two OLEDs emitting blue light, respectively) with a second light emitting component 11 disposed therebetween, the second light emitting component 11 can be configured to emit light, and a 2*2 square matrix on the right side is also composed of four OLEDs 41 (which are two OLEDs emitting red light and two OLEDs emitting green light, respectively) with a light receiving component 12 disposed therebetween. The light emitted by the second light emitting component 11 is reflected by the finger and received by the light receiving component 12. The light receiving component 12 can convert the reflected light reflected by the finger into the electrical signal, so that the processor detects the touch information according to the electrical signal.

Further, the OLED display module further includes: at least one gate line; at least one source line, at least one driving line, and at least one detecting line. One end of the gate line is connected to OLEDs included in at least one row in the array and second light emitting components included in the at least one row, and the other end of the gate line is connected to a driving chip, so that the driving chip controls the OLEDs included in the at least one row and the second light emitting components included in the at least one row to be turned on or off. Taking each gate line being connected to OLEDs and second light emitting components included in one row of the array as an example, when the gate line is turned on, it controls to turn on the OLEDs and the second light emitting components of a corresponding row, and the light receiving components are responsible for receiving the reflected light of the light emitted by the second light emitting components. Then, when the gate line is turned on, it controls to turn on the OLEDs and second light emitting components of a corresponding row, and the light receiving components are responsible for receiving the reflected light of the light emitted by the second light emitting component. On this basis, each area in the entire display module has a process of light emission and light reception. When a finger touches, a light receiving component receives the reflected light reflected by the finger and converts it into an electrical signal, and the processor can detect the touch information through the electrical signal and control the OLED display module according to the touch. One end of the source line is connected to at least one OLED column in the array, and the other end of the source line is connected to the driving chip, so that the driving chip controls a brightness of the at least one OLED column. The second light emitting components are also arranged in columns, one end of the driving line is connected to at least one second light emitting component column in the array, and the other end of the driving line is connected to the driving chip, so that the driving chip controls a brightness of the at least one second light emitting component column. The light receiving components are also arranged in columns, one end of the detecting line is connected to at least one light receiving component column in the array, and the other end of the driving line is connected to the driving chip, so that each light receiving component included in the at least one light receiving component column outputs a respective electrical signal to the driving chip.

In summary, the present application provides an OLED display module having a touch function, including: a plurality of first light emitting components, a plurality of second light emitting components and a plurality of light receiving components, where the plurality of second light emitting components and the plurality of light receiving components are disposed between the plurality of first light emitting components; the second light emitting components are configured to emit light, the light is non-RGB light; and the light receiving components are configured to receive reflected light of the light emitted by the second light emitting components and convert the reflected light into electrical signals; where the electrical signals are configured to detect touch information on the OLED display module. When a display including the OLED display module encounters water, since a refractive index of water is smaller than a refractive index of a finger, when the light receiving components convert the reflected light by the water and finger into electrical signals, strengths of the two electrical signals are significantly different, and on this basis, a processor easily detects the touch information based on the electrical signals. That is, even if the display including the OLED display module encounters water, the normal detection of the touch information cannot be prevented, thereby improving touch reliability and sensitivity. Meanwhile, the present application provides several OLED display modules with the touch function in the above, which differ in the arrangement of the OLEDs, the second light emitting components and the light receiving components, but all follow the following principles: the second light emitting components and the light receiving components are respectively disposed between the OLEDs. In the present application, there is no need to design a sensor layer separately, and the entire OLED display module becomes thinner, which may thereby reduce production processes and improve production efficiency.

FIG. 5 is a schematic diagram of an OLED display according to an embodiment of the present application. As shown in FIG. 5, the OLED display includes an OLED display module 51 with a touch function and a driving circuit 52.

The OLED display module with the touch function includes: a plurality of first light emitting components, a plurality of second light emitting components and a plurality of light receiving components. The plurality of second light emitting components and the plurality of light receiving components are disposed between the plurality of first light emitting components. The first light emitting components are OLEDs, and the OLEDs are configured to implement a display function of the OLED display module. The second light emitting components are configured to emit light to implement the touch function of the OLED display module. The light receiving components are configured to receive reflected light of the light emitted by the second light emitting component and convert the reflected light into electrical signals. The electrical signal is configured to detect touch information on the OLED display module.

Optionally, the plurality of first light emitting components, the plurality of second light emitting components, and the plurality of light receiving components are arranged in an array. In each row of the array, the second light emitting components and the light receiving components are arranged at intervals with N OLED group disposed between adjacent second light emitting component and light receiving component, so that the array includes a plurality of OLED columns, a plurality of second light emitting component columns, and a plurality of light receiving component columns; where N is a positive integer greater than or equal to 1. The OLED group includes a fixed number of OLEDs.

Optionally, the OLED group includes an OLED for emitting red light, an OLED for emitting green light, and an OLED for emitting blue light.

Optionally, the OLED display module further includes: at least one gate line, at least one source line, at least one driving line, and at least one detecting line.

One end of the gate line is connected to OLEDs included in at least one row in the array and second light emitting components included in the at least one row, and the other end of the gate line is connected to a driving chip, so that the driving chip controls the OLEDs included in the at least one row and the second light emitting components included in the at least one row to be turned on or off.. One end of the source line is connected to at least one OLED column in the array, and the other end of the source line is connected to the driving chip, so that the driving chip controls a brightness of the at least one OLED column. One end of the driving line is connected to at least one second light emitting component column in the array, and the other end of the driving line is connected to the driving chip, so that the driving chip controls a brightness of the at least one second light emitting component column. One end of the detecting line is connected to at least one light receiving component column in the array, and the other end of the driving line is connected to the driving chip, so that each light receiving component included in the at least one light receiving component column outputs a respective electrical signal to the driving chip.

Optionally, the plurality of OLEDs form an array, and the array includes a plurality of square matrixes composed of OLEDs. A second light emitting component and a light receiving component are respectively disposed in two adjacent square matrixes.

Optionally, the square matrixes are 2*2 square matrixes, 3*3 square matrixes or 4*4 square matrixes.

Optionally, a separator for isolating light is disposed between the second light emitting components and the light receiving components.

The driving circuit 52 is configured to control the OLEDs and the second light emitting components to be turned on or off, control brightness of the OLEDs and the second light emitting components, and receive respective electrical signals of the light receiving components.

An OLED display provided by the present application includes the OLED display module with the touch function as described in the above embodiments, and the contents and effects thereof are not described herein again.

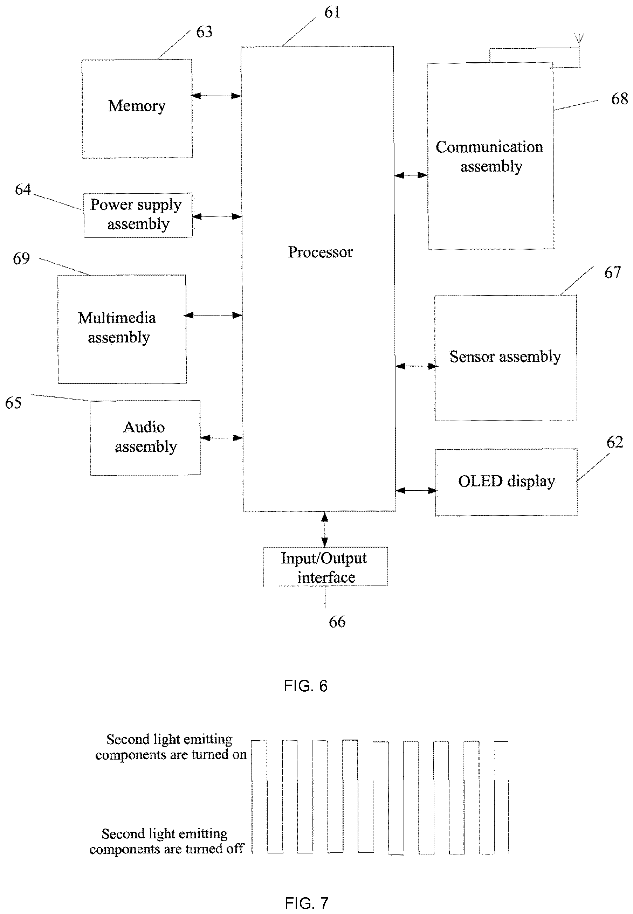

FIG. 6 is a schematic diagram of a terminal device according to an embodiment of the present application. The terminal device may be a terminal device with an OLED display, such as a mobile phone, a tablet computer, or a computer. As shown in FIG. 6, the terminal device includes: a processor 61 and the OLED display 62 in the embodiment corresponding to FIG. 5, where the processor 61 may be one or more of Application Specific Integrated Circuit (ASIC), Digital Signal Processing (DSP), Digital Signal Processing Device (DSPD), Programmable Logic Device (PLD), Field-Programmable Gate Array (FPGA), controller, microcontroller, microprocessor or other electronic components, or the like, which is not limited in the present application.

The processor 61 is specifically configured to determine, according to a preset frequency, that the electrical signals are generated according to light emitted by the second light emitting components, and detect touch information of the display module according to the electrical signals.

Specifically, FIG. 7 is a schematic diagram of emitted light pulses according to an embodiment of the present application. As shown in FIG. 7, when the processor controls the second light emitting components to be turned off, the amplitude of light pulses is at the minimum, and when the processor controls the second light emitting components to be turned on, the amplitude of the light pulses reaches the highest. The light receiving components receive the reflected light of the light, and convert the light into the electrical signals having a preset frequency. When receiving the electrical signals of the preset frequency, the processor may determine that the electrical signals are generated according to the light of the second light emitting components, and detect touch information of the display module according to the electrical signals. For example, when a signal strength of an electrical signal is greater than the preset strength, the processor detects the touch information, and determines a touch position according to the touch information, and control the OLED display module according to the touch at the position; when the signal strength of the electrical signal is less than or equal to the preset strength, the processor does not need to detect the touch information.

On this basis, when other objects generate an emitted light, since a frequency of the emitted light is not equal to the above-mentioned preset frequency, the processor can recognize which electrical signals are invalid electrical signals, thereby improving touch reliability.

Optionally, as shown in FIG. 6, the terminal device further includes one or more of the following components: a memory 63, a power supply assembly 64, an audio assembly 65, and an input/output (I/O) interface 66, sensor assembly 67, communication assembly 68, multimedia assembly 69, and the like.

The memory 63 is configured to store various types of data to support operations at the terminal device. Examples of these data include instructions for any application or method operating on the terminal device, contact data, phone book data, messages, pictures, videos, or the like. The memory 63 can be implemented by any type of volatile or non-volatile storage device or a combination thereof, such as Static Random Access Memory (SRAM), Electrically Erasable Programmable Read-Only Memory (EEPROM), Erasable Programmable Read-Only Memory (EPROM), Programmable Read-only Memory (PROM), Read-Only Memory (ROM), magnetic memory, flash memory, disk or optical disk.

Power supply assembly 64 provides power to various components of the terminal device. Power supply assembly 64 may include a power management system, one or more power supplies, and other components associated with generating, managing, and distributing power for the terminal device.

The front and/or the rear cameras can receive external multimedia data when the terminal device is in an operation mode, such as a shooting mode or a video mode. Each of the front and rear cameras can be a fixed optical lens system or have focal length and optical zoom capabilities.

The audio assembly 65 is configured to output and/or input an audio signal. For example, the audio assembly 65 includes a Microphone (MIC) that is configured to receive an external audio signal when the terminal device is in the operation mode, such as a calling mode, a recording mode, and a voice recognition mode. The received audio signal may be further stored in the memory 63 or transmitted via the communication assembly 68. In some embodiments, the audio assembly 65 further includes a speaker configured to output the audio signal.

The I/O interface 66 provides an interface between the processor and a peripheral interface module. The peripheral interface module may be a keyboard, a click wheel, a button, or the like. These buttons may include, but are not limited to, a main bar button, a volume button, a start button, and a lock button.

The sensor assembly 67 includes one or more sensors for providing status assessment of various aspects for the terminal device. For example, the sensor assembly 67 can detect on/off state of the terminal device, a relative positioning of the assemblies, for example, the assemblies are a display and a keypad of the terminal device, and the sensor assembly 67 can also detect a position change of the terminal device or an assembly of the terminal device, whether there is a contact between the user and the terminal device, orientation or acceleration/deceleration of the terminal device, and a temperature change of the terminal device. The sensor assembly 67 may include a proximity sensor configured to detect a presence of nearby objects without any physical contact. The sensor assembly 67 may further include a light sensor, such as a Complementary Metal Oxide Semiconductor (CMOS) or a Charge-coupled Device (CCD) image sensor for use in imaging applications. In some embodiments, the sensor assembly 67 may also include an acceleration sensor, a gyro sensor, a magnetic sensor, a pressure sensor, or a temperature sensor.

The communication assembly 68 is configured to facilitate wired or wireless communication between the terminal device and other devices. The terminal device can access a wireless network based on communication standards, such as Wireless-Fidelity (WiFi), 2 Generation (2G) or 2 Generation (3G), 4 Generation (4G) or 5 Generation (5G), or their combination. In an exemplary embodiment, the communication assembly 68 receives a broadcast signal or broadcast associated information from an external broadcast management system via a broadcast channel. In an exemplary embodiment, the communication assembly 68 further includes a Near Field Communication (NFC) module to facilitate a short range communication. For example, the NFC module may be achieved based on Radio Frequency Identification (RFID) technology, Infrared Data Association (IrDA) technology, Ultra Wide Band (UWB) technology, Blue Tooth (BT) technology and other technologies.

It should be noted that the terminal device provided by the present application includes an OLED display, where the contents of the OLED display can refer to the contents of the OLED display provided by the above-mentioned embodiments of the present application. This application will not be described herein again.

Finally, it should be noted that the above-mentioned embodiments are merely illustrative of the technical solutions of the present invention, and are not intended to limit thereto; although the present invention has been described in detail with reference to the above-mentioned embodiments, those skilled in the art will understand that the technical solutions described in the above-mentioned embodiments may be modified, or some or all of the technical features therein may be equivalently substituted; and the modifications or substitutions do not deviate the corresponding technical solution from the scope of the technical solutions of the embodiments of the present invention.

## Claims

1. An OLED display module with a touch function, comprising: a plurality of first light emitting components, a plurality of second light emitting components and a plurality of light receiving components, wherein the plurality of second light emitting components and the plurality of light receiving components are disposed between the plurality of first light emitting components;
wherein the first light emitting components are organic light emitting diodes (OLEDs), and the OLEDs are configured to implement a display function of the OLED display module;
the second light emitting components are configured to emit light to implement the touch function of the OLED display module; and
the light receiving components are configured to receive reflected light of the light emitted by the second light emitting component and convert the reflected light into electrical signals; wherein the electrical signals are configured to detect touch information on the OLED display module.

2. The OLED display module of claim 1, wherein the plurality of first light emitting components, the plurality of second light emitting components, and the plurality of light receiving components are arranged in an array;
in each row of the array, the second light emitting components and the light receiving components are arranged at intervals with N OLED group disposed between adjacent second light emitting component and light receiving component, so that the array comprises a plurality of OLED columns, a plurality of second light emitting component columns, and a plurality of light receiving component columns;
wherein N is a positive integer greater than or equal to 1, and the OLED group comprises a fixed number of OLEDs.

3. The OLED display module of claim 2, wherein the OLED group comprises an OLED for emitting red light, an OLED for emitting green light, and an OLED for emitting blue light.

4. The OLED display module of claim 2 or 3, further comprising: at least one gate line, at least one source line, at least one driving line, and at least one detecting line;
wherein one end of the gate line is connected to OLEDs comprised in at least one row in the array and second light emitting components comprised in the at least one row, and the other end of the gate line is connected to a driving chip, so that the driving chip controls the OLEDs comprised in the at least one row and the second light emitting components comprised in the at least one row to be turned on or off;
one end of the source line is connected to at least one OLED column in the array, and the other end of the source line is connected to the driving chip, so that the driving chip controls a brightness of the at least one OLED column;
one end of the driving line is connected to at least one second light emitting component column in the array, and the other end of the driving line is connected to the driving chip, so that the driving chip controls a brightness of the at least one second light emitting component column;
one end of the detecting line is connected to at least one light receiving component column in the array, and the other end of the driving line is connected to the driving chip, so that each light receiving component comprised in the at least one light receiving component column outputs a respective electrical signal to the driving chip.

5. The OLED display module of claim 1, wherein the plurality of first light emitting components form an array, and the array comprises a plurality of square matrixes composed of OLEDs;
a second light emitting component and a light receiving component are respectively disposed in two adjacent square matrixes.

6. The OLED display module of claim 5, wherein the square matrixes are 2*2 square matrixes, 3*3 square matrixes or 4*4 square matrixes.

7. The OLED display module of any one of claims 1 to 6, wherein a separator for isolating light is disposed between the second light emitting components and the light receiving components.

8. An OLED display comprising an OLED display module of any one of claims 1-7.

9. A terminal device comprising an OLED display of claim 8.
